(19) **Europäisches Patentamt**

**European Patent Office**

**Office européen des brevets**

(11) **EP 0 740 776 B1**

(12) **EUROPÄISCHE PATENTSCHRIFT**

(45) Veröffentlichungstag und Bekanntmachung des Hinweises auf die Patenterteilung:
**12.06.2002 Patentblatt 2002/24**

(51) Int Cl.⁷: $G01D\ 5/14$, G01D 5/16

(21) Anmeldenummer: **95937788.8**

(86) Internationale Anmeldenummer:
**PCT/DE95/01626**

(22) Anmeldetag: **22.11.1995**

(87) Internationale Veröffentlichungsnummer:
**WO 96/16316 (30.05.1996 Gazette 1996/25)**

(54) **ANORDNUNG ZUR BERÜHRUNGSLOSEN DREHWINKELERFASSUNG EINES DREHBAREN ELEMENTS**

ARRANGEMENT FOR THE CONTACTLESS DETERMINATION OF THE ANGLE OF ROTATION OF A ROTATABLE COMPONENT

SYSTEME DE DETERMINATION SANS CONTACT DE L'ANGLE DE ROTATION D'UN ELEMENT ROTATIF

(84) Benannte Vertragsstaaten:
**DE FR GB IT SE**

(30) Priorität: **22.11.1994 DE 4441504**

(43) Veröffentlichungstag der Anmeldung:
**06.11.1996 Patentblatt 1996/45**

(73) Patentinhaber: **ROBERT BOSCH GMBH**
**70442 Stuttgart (DE)**

(72) Erfinder:
• **DUKART, Anton**
**D-76744 Wörth (DE)**
• **WINNER, Hermann**
**D-76229 Karlsruhe (DE)**
• **STEINLECHNER, Siegbert**
**D-71229 Leonberg (DE)**
• **ZABLER, Erich**
**D-76297 Stutensee (DE)**

(56) Entgegenhaltungen:
**DE-U- 9 302 758          US-A- 4 791 366**

• **PATENT ABSTRACTS OF JAPAN vol. 9 no. 156 (P-368) ,29.Juni 1985 & JP,A,60 031005 (TOSHIBA KK) 16.Februar 1985,**
• **SENSORS AND ACTUATORS, Bd. A22, Nr. 1/3, März 1990 LAUSANNE,CH, Seiten 795-798, XP 000358533 EIKEL ET AL. 'A Thin-Film Magnetoresistive Angle Detector'**
• **PATENT ABSTRACTS OF JAPAN vol. 6 no. 22 (P-101) ,9.Februar 1982 & JP,A,56 143905 (MATSUSHITA ELECTRIC IND CO) 10.November 1981,**
• **ELEKTRONIK, Bd. 34, Nr. 10, Mai 1985 MÜNCHEN,DEUTSCHLAND, Seiten 99-102, PETERSEN 'Magnetoresistive Sensoren im Kfz'**
• **PATENT ABSTRACTS OF JAPAN vol. 11 no. 130 (E-502) ,23.April 1987 & JP,A,61 274508 (SONY CORP) 4.Dezember 1986,**

**Beschreibung**

Stand der Technik

Die Erfindung betrifft eine Anordnung zur berührungslosen Drehwinkelerfassung eines drehbaren Elements, bei der unter Auswertung von magnetisch beeinflußbaren elektrischen Eigenschaften an einem Sensor eine vom drehbaren Element erzeugte oder beeinflußte magnetische Feldstärke detektiert wird, nach der Gattung des Hauptanspruchs.

Eine Anordnung dieser Art, mit der eine Drehwinkelerfassung durchführbar ist, ist beispielsweise aus der EP-0 217 478 B1 bekannt. Hier werden mit einem Winkelsensor, der aus zwei parallelen dünnen Filmen aus magnetisch weichem Material gebildet ist, die von einem drehenden Magneten ausgehenden magnetischen Feldlinien erfaßt und ausgewertet. Die magnetischen Filme im Winkelsensor sind derart angebracht, daß in der Ebene der Feldlinien jeweils Stromzuführungs- und Spannungsmeßanschlüsse an den beiden Filmen um 45° gegeneinander versetzt angeschlossen sind. Durch eine Widerstands-Anisotropie in den Filmen ergibt sich ein von der Richtung der Winkellage der Feldlinien abhängiges Sensorsignal, das in einer Auswerteschaltung verarbeitbar ist. Bei dieser bekannten Anordnung ist jedoch nur eine Winkelauswertung im Bereich von 180° auswertbar, was zu einem erhöhten Aufwand bei der einwandfreien Erfassung der Winkellage führt.

Weiterhin ist eine Abtastung von inkrementalen Strukturen an Zahnrädern aus ferromagnetischem Material bekannt, bei der beispielsweise für die Zündungssteuerung an Verbrennungsmotoren oder zur Drehzahlerfassung für Antiblockiersysteme die Abtastung mit berührungslosen Sensoranordnungen vorgenommen wird. Beispielhaft ist in dem VDI-Bericht Nr. 509, (VDI-Verlag 1984), Seiten 263 bis 268, im Aufsatz "Neue, alternative Lösungen für Drehzahlsensoren im Kraftfahrzeug auf magnetoresistiver Basis" beschrieben, wie mit magnetischen Tangentialsonden als Sensoren eine besonders einfache und insbesondere gegen Luftspaltschwankungen unempfindliche Abtastung von Inkrementalstrukturen an drehenden Wellen oder Zahnrädern durchführbar ist. Dies ist möglich, weil das Vorzeichen der Tangentialkomponente eines im Sensor befindlichen Dauermagneten nicht von der Größe des Luftspaltes zwischen dem Sensor und den drehbaren Elementen abhängt. Diese Vorzeichenänderung kann nur durch eine rotorische Weiterbewegung der Welle oder des Zahnrades erfolgen, wodurch eine inkrementale Drehwinkeländerung eines Zahnrades erfaßt werden kann.

In der oben genannten, bekannten Druckschrift ist auf Seite 264 unter Punkt 3.3 auch der Einsatz von Sensoren beschrieben, die sich den sogenannten Halleffekt zur Abtastung einer Änderung eines magnetischen Feldes zu Nutze machen. Diese in bekannter Weise ausgeführten Hallsensoren nutzen eine Ablenkung eines zwischen zwei Anschlußpolen fließenden Stromes durch ein senkrecht dazu stehendes magnetisches Feld aus. Eine Ladungsträgerverschiebung in Richtung der magnetischen Feldlinien führt hierbei zum Entstehen einer sogenannten Hallspannung, die quer zur Stromflußrichtung abnehmbar ist. Unter Ausnutzung der für diesen Zweck optimalen Eigenschaften von Hallstrukturen in Halbleitermaterialien verläuft die Stromflußrichtung in dieser Hallstruktur in der Regel koplanar in der Ebene eines sogenannten Halbleiter-Wafers, zum Beispiel eines Silizium-Halbleiter-Chips.

Die bei der Abtastung an drehbaren Elementen notwendige Tangentialfelderfassung ist hier insofern nachteilig, als daß durch die unvermeidbare tangentiale Längsausdehnung des Hallsensors herkömmlicher Art ein erheblicher Luftspalt zwischen dem drehbaren Element und dem Sensor entsteht (ca. 2 mm bis 4 mm) und der Effekt der senkrecht zur Waferebene verlaufenden Feldlinien stark verringert wird. Da die Feldstärke exponentiell zum Abstand zwischen dem drehbaren Element und dem Sensor abnimmt, wird der auswertbare Meßeffekt hier sehr klein. Um ein vom Luftspalt unabhängiges Signal zu erfassen, muß bei der bekannten Methode eine differentielle Erfassung des radial gerichteten Feldes mit zwei Hallsensoren durchgeführt werden, die eventuell auch besonders an die Inkrementweiten (Zahnabstand bei Zahnrädern) angepaßt sind. Eine Anwendung von Materialien mit höherer und anders gerichteter Empfindlichkeit, wie zum Beispiel magnetoresistive Dünnschichtsensoren, Permalloysensoren oder auch sogenannte Pseudohallsensoren, als Alternative zu den Silizium-Halbleiter-Hallsensoren ist möglich, die Herstellungstechnologie ist bei diesen Materalien allerdings aufwendig, insbesondere, wenn sie mit einem Verstärkerschaltkreis verbunden bzw. mit ihm integriert werden sollen.

Es sind weiterhin Hallsensoren bekannt (aus "Sensors and Materials", 5,2 (1993)091-101, MYU, Tokyo, der Aufsatz "Simulation, Design and Fabrication of a Vertical Hall Device for Two-Dimensional Magnetic Field Sensing" von M. Parajape, Lj. Ristic und W. Allegretto), bei denen sich die Hallstruktur senkrecht zur Waferfläche in die Tiefe eines Silizim-Chips ausdehnt. Somit wird hier eine Erfassung des tangential gerichteten Feldes möglich, ohne dabei den Luftspalt untragbar zu vergrößern.

Diese, aus der zweiten Druckschrift bekannten Hallsensoren beanspruchen eine geringe Ausdehnung und damit einen sehr geringen Luftspalt, welcher sich im wesentlichen nur aus der Waferdicke (ca. 400 μm) zusätzlich einer Schutzschicht zusammensetzt. Auch ist aus dieser Druckschrift bekannt, mit zwei um 90° gegeneinander versetzten Hallsensoren auch Komponenten eines zweidimensionalen magnetischen Feldes zu erfassen

Vorteile der Erfindung

Die erfindungsgemäße Anordnung zur berührungslosen Drehwinkelerfassung eines drehbaren Elements, unter Ausnutzung des Halleffekts oder eines magnetoresistiven Effekts, mit den Merkmalen des Anspruchs 1, hat den Vorteil, daß beispielsweise die Tangentialfelderfassung eines vom drehbaren Element erzeugten oder beeinflußten magnetischen Feldes mit geringem Luftspalt mit hoher Genauigkeit möglich ist. Die vertikal in einer Fläche, beispielsweise einem Siliziumwafer, angeordneten Sensorelemente gestatten aufgrund ihrer geringen Abmessungen in der planaren Ebene eine effektive Plazierung des Sensors in der Nähe der drehbaren Elemente, wobei durch eine zusätzliche, räumliche mikromechanische Strukturierung die Empfindlichkeit des Sensors erhöht werden kann. Die zur Signalaufbereitung erforderlichen elektronischen Schaltkreise können hierbei vorteilhaft in den selben Silizium-Chip wie die Sensorelemente integriert werden. Hierbei ist, wie oben erwähnt, der Nachteil eines inkrementalen Drehwinkel-Meßsystems vermeidbar, daß es auf einer Zählung der Inkremente beruht, die von außen bleibend gestört werden kann.

Aus der Druckschrift Patent Abstracts of Japan Vol.9 no. 156 (P-368), 29.06.1985 ist eine Anordnung zur berührungslosen Drehwinkelerfassung bekannt, bei der eine Scheibe, die unterteilt ist in einen Nord- und einen Südpol, mit Hilfe zweier um 90° versetzter Sensoren abgetastet wird. Dabei wird ein Sensor mit einem sinusförmigen und der andere mit einem cosinusförmigen Strom beaufschlagt. Die sich einstellenden Ausgangsspannungen der beiden Sensoren werden einander überlagert. Die sich dabei ergebende Summenspannung ist vom Drehwinkel abhängig und wird zur Bestimmung des Drehwinkels ausgewertet.

Die US-PS 4 791 366 zeigt eine Anordung zur Drehwinkelerfassung, bei der eine rotierende Scheibe mit jeweils zwei Nord- und zwei Südpolen mit Hilfe zweier Sensoren abgetastet wird. Die Sensoren sind gegeneinander um einen Winkel von θs versetzt. Einer der Sensoren wird mit einem sinusförmigen, der andere mit einem cosinusförmigen Strom beaufschlagt. Die beiden Ausgangsspannungen der Sensoren werden einander überlagert und mithilfe einer Phasenkomperatorschaltung wird der in der überlagerten Spannung enthaltene Drehwinkel ermittelt.

Die EP 0 217 478 A beschreibt verschiedene berührungslose Winkelsensoren. Dabei umfaßt das drehbare Element einen Magneten, dessen Feld mit Hilfe zweier Dünnfilmsensorelemente, die gegeneinander um 45° verdreht sind, ausgewertet wird. In einer Signalaufbereitungsschaltung wird aus den Ausgangsschaltungen der Sensorelemente der Drehwinkel des drehbaren Elementes bestimmt.

Die Druckschrift Sensors and Actuators, Band A22 Nr. 1/3, März 1990, Lausanne, CH Seiten 795-798 (XP 000358533), Eikel et al., "A Thin-Film Magnetoresistive Angle Detector" beschreibt verschiedene Winkelsensoren, die entweder nach dem AMR-Effekt (Anisotropic-Magneto-Resistance-Effect) oder nach dem Halleffekt arbeiten. Solche Sensoren umfassen üblicherweise zwei Sensorelemente, die gegeneinander um einen vorgebbaren Winkel, von beispielsweise 45° verdreht sind. Den Sensorelementen werden Ströme zugeführt, die für das eine Sensorelement sinusförmig und für das andere cosinusförmig sind. Aus den überlagerten Ausgangsspannungen der Sensorelemente läßt sich der Drehwinkel bestimmen.

Aus der Druckschrift Patent Abstracts of Japan Vol.6 no.22 (P-101), 09.02.1982 ist eine weitere Anordnung zur berührungslosen Drehwinkelerfassung bekannt, die zwei Hall-Elemente umfaßt, wobei einem Hall-Element ein sinusförmiger und dem anderen ein cosinusförmiger Strom zugeführt wird. Die Ausgangssignale der Hall-Elemente werden addiert und aus der sich einstellenden Summenspannung wird der Drehwinkel bestimmt.

Mit der Anwendung von zwei um 90° gegeneinander verdrehten, vertikalen Hall-Sensorelementen oder von zwei um 45° gegeneinander verdrehten AMR-Sensorelementen gemäß der Erfindung an drehbaren Elementen können zwei Komponenten eines äußeren, in der Ebene der die Sensorelemente tragenden Fläche liegenden Feldes auf einfache Weise sehr genau erfaßt werden. Die Drehlage des drehbaren Elementes verändert hierbei in gleicher Weise die Drehlage des erzeugten oder beeinflußten magnetischen Feldes und somit die Feldkomponenten in der Ebene der die Sensorelemente tragenden Fläche. Bei der erfindungsgemäßen Anordnung ist also jederzeit auch die absolute Drehlage des drehbaren Elementes erfaßbar und nicht auf Inkremente beschränkt. Die elektronische Auswertung kann auf vorteilhafte Weise vorgenommen werden, da sich die von den Feldkomponenten erzeugten Signale nach einem Sinus- bzw. Cosinusgesetz ändern und eine Ermittlung des Drehlagewertes mit analogen oder digitalen Schaltkreisen unter schaltungstechnischer Umsetzung von trigonometrischen Formeln durchführbar ist. Eine solche vorteilhafte Auswertung ist möglich, sofern eines der Sensorelemente mit einem sinus- und das andere mit einem cosinusförmigen Signal angeregt wird. Besonders vorteilhaft ist, daß die schaltungstechnische Umsetzung für die Auswertung von Signalen von wählbaren Sensoren geeignet ist, wobei Speisesignale mit Steuersignalen in geeigneter Weise, insbesondere multiplikativ verknüpft werden.

Werden die Sensorelemente mit geeigneten rechteckförmigen Signalen einer Kreisfrequenz ω, beispielsweise mit zwei rechteckförmigen Spannungen mit 50 % Tastverhältnis, die zueinander um eine Viertelperiode verschoben sind, angesteuert, ergeben sich besonders vorteilhafte Möglichkeiten. So sind solche Rechtecksignale einfacher zu erzeugen als phasen- und amplitudenkonstante Sinus- bzw. Cosinussignale.

Außerdem treten keine Probleme mit der Amplituden- bzw. Phasenkonstanz dieser Signale auf.

Es ist eine ratiometrische analoge Ausgangsspannung einfach erzeugbar, wahlweise auch ein pulsbreitenmoduliertes Ausgangssignal. Nullpunktverschiebungen bzw. Eichungen sowie die Kompensation von statischen Fehlern des Sensors und/oder der Auswerteschaltung sind analog oder digital realisierbar und die gesamte Anordung von Sensor und Auswerteschaltung ist vollständig integrierbar.

Durch Messung des Stromverbrauchs bei der Erzeugung der Rechtecksignale läßt sich die Temperatur des Sensors ermitteln, dadurch ist eine vorteilhafte Kompensation der temperaturabhängigen Eigenschaften des Sensors möglich.

In einer weiteren vorteilhaften Ausführung der Erfindung werden die beiden Sensoren mit Gleichspannungen angesteuert und die erzeugte Ausgangsspannung wird mit Hilfe zweier elektronischer Schalter verarbeitet. Auch mit einer solchen Ausführungsform kann eine Nullpunktsverschiebung kompensiert werden.

Weitere vorteilhafte, Ausführungsformen der Erfindung sind in den abhängigen Ansprüchen angegeben.

Zeichnung

Ausführungsbeispiele der Erfindung werden anhand der Zeichnung erläutert. Es zeigen:

Figur 1 einen Schnitt durch eine Drehwinkelerfassungsanordnung an einer drehbaren Welle mit einer schematischen Darstellung einer Sensoranordnung;

Figur 2 eine Prinzipdarstellung der Sensoranordnung nach Figur 1 mit zwei um 90° gegeneinander versetzten Hallsensoren;

Figur 3 die Kurvenverläufe der Sensorausgangsspannungen und der resultierenden Ausgangssignale und

Figur 4 ein Blockschaltbild einer Auswerteschaltung zur Ermittlung des Drehwinkels der drehbaren Welle.

Die Figuren 5 bis 7 zeigen Ausführungsbeispiele für Ansteuerungen mit rechteckförmigen Signalen und in Figur 8 ist eine konkrete Schaltung dargestellt.

Die Figuren 9 und 10 zeigen Ausführungsformen, bei denen die Ansteuerung der Sensoren mit Gleichspannung erfolgt und die Ausgangssignale unter Verwendung von Schaltern verarbeitet werden.

Beschreibung der Ausführungsbeispiele

Die Erfindung wird anhand von Ausführungsbeispielen erläutert, bei denen die Sensorelemente z. B. zwei Hallsensoren sind. Mit anderen magnetoresistiven Sensoren, also Sensoren, deren Widerstand sich magnetfeldabhängig ändert, läßt sich die Erfindung ebenfalls realisieren.

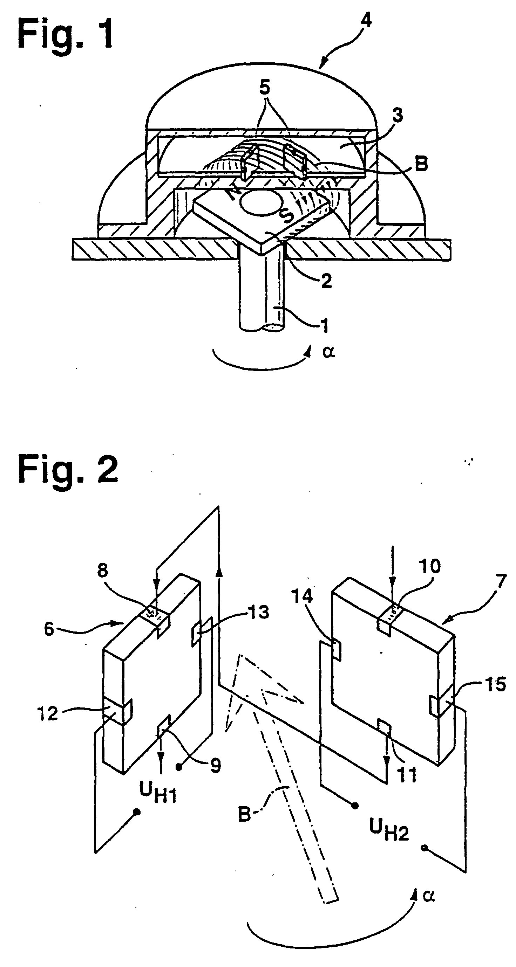

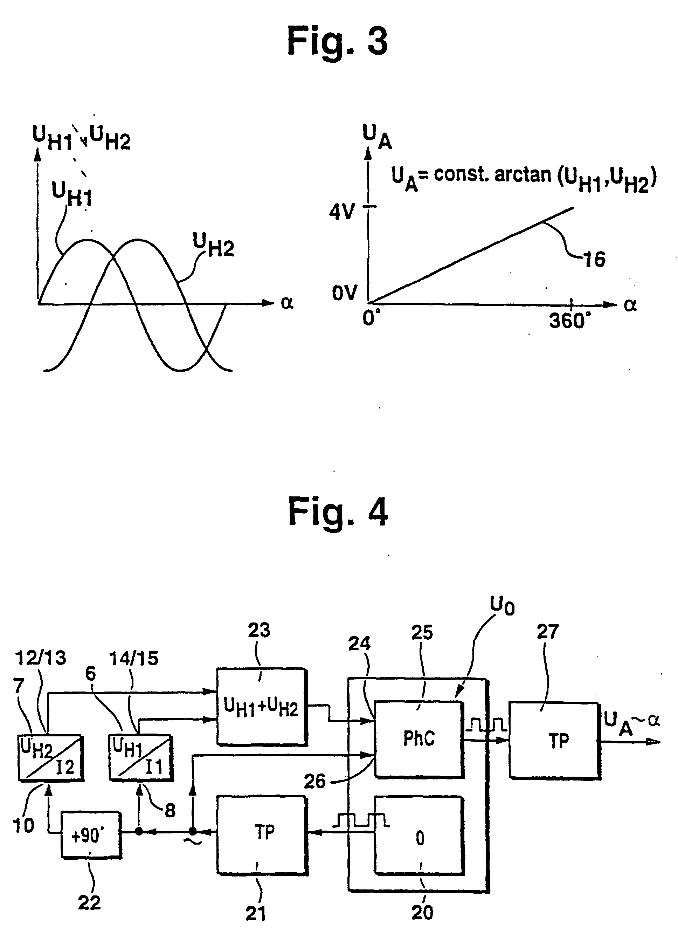

In der Figur 1 ist eine um den Winkel a drehbare Welle 1 gezeigt, die an ihrem Ende einen Dauermagneten 2 als mitdrehbares Element trägt. $\alpha$ ist der Winkel, der gemessen werden soll. Die magnetischen Feldlinien B des Magneten 2 verlaufen hierbei durch ein oberes Teil 3 eines Gehäuses 4, wobei in diesem oberen Teil 3 eine Sensoranordnung 5, bestehend aus zwei gegeneinander um 90° versetzten Hallsensoren (vgl. Figur 2), fest angeordnet ist. Die Darstellung der Hallsensoren ist hier nur schematisch, da diese in eine Schicht integriert sein können und dadurch sichtbar nicht mehr in Erscheinung treten müssen. Die Richtungskomponenten der Feldlinien B verursachen hier spezifische Ausgangssignale der beiden Hallsensoren, wodurch sowohl die absolute Drehlage als auch eine Änderung der Drehlage um eine beliebige Winkeländerung $\alpha$ mit einer nachfolgenden anhand der Figuren 4 bis 10 beschriebenen elektronischen Schaltung ausgewertet werden kann.

In der Figur 2 ist die Lage und die Beschaltung von zwei Hallsensoren 6 und 7 als Bestandteil der Sensoranordnung 5 gemäß Figur 1 in prinzipieller Weise räumlich dargestellt. Der Hallsensor 6 weist Stromanschlüsse 8 und 9 und der Hallsensor 7 Stromanschlüsse 10 und 11 auf, durch die ein Strom I in der gezeigten Richtung hindurch fließt. Quer zu der Stromflußrichtung des Stromes I sind an Anschlüssen 12 und 13 (Hallsensor 6) und Anschlüssen 14 und 15 (Hallsensor 7) Hallspannungen $U_{H1}$ und $U_{H2}$ abnehmbar. Die magnetischen Feldlinien B eines Magneten 2 (vgl. Figur 1) weisen hierbei jeweils in der Strecke zwischen den gegenüberliegenden Anschlüssen 12 und 13 bzw. zwischen den Anschlüssen 14 und 15 Feldkomponenten auf, die in der als Halleffekt bekannten Weise zu einer Ablenkung der Ladungsträger des Stromes I führen. Der damit verbundene Potentialunterschied führt zu der Hallspannung $U_{H1}$ zwischen den Polen bzw. Anschlüssen 12 und 13 sowie zu der Hallspannung $U_{H2}$ zwischen den Polen bzw. Anschlüssen 14 und 15, die in der nachfolgend beschriebenen Art und Weise ausgewertet können. Eine Änderung der Richtung der Feldlinien B durch eine Drehung um den Winkel $\alpha$ führt demgemäß zu einer unterschiedlichen Beeinflussung des Halleffekts in den Hallsensoren 6 und 7. Dies kann über die elektronische Auswertung der Hallspannungen $U_{H1}$ und $U_{H2}$ zur Berechnung des Drehwinkels $\alpha$ herangezogen werden.

Die beiden Hallsensoren 6 und 7 können daher zur Auswertung eines vom drehbaren Element (Magnet 2) erzeugten magnetischen Feldes im vollen Drehbereich von 360° herangezogen werden. Beispielsweise werden die Hallsensoren 6 und 7 durch in einen Silizium-Halbleiter-Wafer eingebrachte vertikale Hallstrukturen derart hergestellt, daß aufgrund ihrer geringen Abmessungen in der planaren Ebene des Wafers eine präzise und nahezu punktförmige Plazierung der Sensoranordnung 5 in der Nähe des drehbaren Elementes möglich ist, wobei durch eine zusätzliche, räumliche, mikromechanische Strukturierung die Empfindlichkeit der Sensoranordnung 5 erhöht werden kann. Die zur Signalaufbereitung erforderlichen elektronischen Schaltkreise können hierbei vorteilhaft in den selben Silizium-Chip wie die Hallsensoren 6 und 7 integriert werden.

In Figur 3 ist der Verlauf der Hallspannung $U_{H1}$ und der Hallspannung $U_{H2}$ in Abhängigkeit vom Drehwinkel a dargestellt. Der Verlauf der Hallspannung $U_{H1}$ in Abhängigkeit vom Drehwinkel $\alpha$ erfolgt hierbei nach einem Sinusgesetz und der der Hallspannung $U_{H2}$ nach einem Cosinusgesetz, wobei sich folgende mathematischen Beziehungen ergeben:

$$U_{H1} = C_1 \cdot I_1 \cdot B \cdot \cos \alpha, \qquad (1)$$

$$U_{H2} = C_2 \cdot I_2 \cdot B \cdot \sin \alpha, \qquad (2)$$

wobei

$U_{H1}$ die Hallspannung des Hallsensors 6,
$U_{H2}$ die Hallspannung des um 90° versetzten Hallsensors 7,
$C_1$, $C_2$ Materialkonstanten der Hallsenssoren 6 und 7,
B die senkrecht zur Ebene der Hallsensoren 6 und 7 auftretende magnetische Feldstärke (unter der Voraussetzung, daß die Feldstärke an beiden Hallsensoren 6 und 7 gleich ist (B1=B2)) und
$\alpha$ der Drehwinkel des sich drehenden Elements (Magnet 2) ist.

Durch eine, in einer elektronischen Auswerteschaltung herzustellende Verknüpfung der Hallspannungen $U_{H1}$ und $U_{H2}$ wird eine Ausgangsspannung $U_A$ erzeugt, die in sehr guter Näherung proportional zum Drehwinkel $\alpha$ des drehbaren Elements 2 ist (vgl. Verlauf der Kurve 16 im rechten Teil der Figur 3). Die mathematische Auswertung kann mit einer entsprechenden schaltungsmäßigen Realisierung beispielsweise wie folgt vorgenommen werden:

$$\alpha = \arctan (U_{H1}/U_{H2}) \qquad (3),$$

womit der Drehwinkel $\alpha$ aus der Ausgangsspannung $U_A$ in der Auswerteschaltung bestimmbar ist.

Figur 4 zeigt beispielhaft eine mögliche Ausführungsform einer Auswerteschaltung, mit der die oben beschriebene Drehwinkelauswertung an der erfindungsgemäßen Anordnung durchgeführt werden kann. Ausgehend von einem spannungsgeregelten Oszillator 20 mit nachgeschaltetem Tiefpaß 21 wird hier ein erster sinusförmiger Wechselstrom $I_1$ erzeugt, der am Stromanschluß 8 des Sensors anliegt und folgende Zeitfunktion aufweist:

$$I_1(t) = I_O \cdot \sin (\omega \cdot t).$$

Am Ausgang eines Phsenverzögerungsgliedes 22 liegt ein um 90° verschobener Strom $I_2$ mit der Zeitfunktion

$$I_2(t) = I_O \cdot \cos (\omega \cdot t)$$

an, mit dem der Sensor an seinem Stromanschluß 10 beaufschlagt wird. Die Sensorelemente bilden daraufhin ein Produkt, die Spannungen $U_{H1}$ und $U_{H2}$, an den Ausgängen 12/13 und 14/15 ergeben sich wie folgt:

$$U_{H1}(t, \alpha) = C_1 \cdot B_1 \cdot \cos (K\alpha) \cdot I_1(t)$$

und

$$U_{H2}(t, \alpha) = C_2 \cdot B_2 \cdot \sin (K\alpha) \cdot I_2(t),$$

wobei die Konstanten $C_1 = C_2 = C$ und die Feldkomponenten $B_1 = B_2 = B$ sind $\alpha$ ist der zu messende Winkel, das heißt der Winkel zwischen dem Steuermagnetfeld und dem Sensor. Der Faktor K beträgt 1 bei Hall-, 2 bei AMR-Sensoren. Durch Addition dieser Signale entsteht eine zum Strom $I_1$ bzw. $I_2$ um $K\alpha$ phasenverschobene Spannung U(t).In einer Summationsschaltung 23 wird die Summe aus den beiden Spannungen $U_{H1}(t)$ und $U_{H2}(t)$ gebildet, so daß sich eine Spannung U(t) nach folgender Beziehung unter Anwendung trigonomerischer Formeln ergibt: $U(t) = U_{H1}(t) + U_{H2}(t)$

$$U(t) = C \cdot B \cdot I_O \cdot (\cos(K\alpha) \cdot \sin(\omega \cdot t) + \sin(K\alpha) \cdot$$

$$\cos(\omega \cdot t)).$$

Diese Gleichung kann umgeformt werden zu:

$$U(t) = C \cdot B \cdot I_O \cdot \sin(\omega \cdot t + K\alpha),$$

da allgemein gilt:

$$\sin(a + b) = \sin(a) \cdot \cos(b) + \sin(b) \cdot \cos(a).$$

Die Spannung U(t) liegt an einem ersten Eingang 24 eines Phasenkomparators 25 an, an dessen zweiten Eingang 26 das Ausgangssignal (U = const $\cdot$ sin($\omega \cdot$ t)) des Tiefpasses 21 anliegt. Das Ausgangssignal des Phasenkomparators 25 stellt hier eine Rechteckspannung mit der Impulshöhe $U_O$, entsprechend der versorgungsspannung des Phasenkomparators 25, dar. Die Impulsdauer des Rechtecksignals entspricht der Phasendifferenz $K\alpha$ der beiden Eingangsspannungen, welche proportional ist zu dem geometrischen Drehwinkel $\alpha$, der gemessen werden soll. Das Rechtecksignal wird mittels eines weiteren Tiefpasses 27 geglättet und ergibt somit das zum Drehwinkel $\alpha$ der in der Figur 1 dargestellten drehbaren Welle 1 proportionale Ausgangssignal $U_A$.

Es wird also letztendlich ein Phasenvergleich von i und U(t) durchgeführt, der zur pulsweitenmodulierten Spannung führt, die durch einen Tiefpaß in eine Analogspannung gewandelt wird.

Anstatt der Phasenverschiebung des Stromes kann auch eine Spannung nach dem Sensorelement um 90° phasenverschoben werden.

Der Kern der Erfindung ist also letztendlich die Ausnutzung von $\sin(a + b) = \sin(a) \cdot \cos(b) + \sin(b) \cdot \cos(a)$ für die Auswertung der Signale der Sensoren, die Speisesignale mit Steuersignalen multiplikativ verknüpfen, so daß o. g. Ausdruck entsteht.

Werden die beiden Sensorelemente nicht mit sinusförmigen sondern mit rechteckförmigen Signalen der Kreisfrequenz $\omega$ angesteuert, ergibt sich eine günstige Auswertemöglichkeit. Die Rechtecksignale besitzen dabei ein Tastverhältnis von 50 % und sind gegeneinander um eine Viertelperiode verschoben. Solche Rechtecksignale sind sehr einfach mit Flip-Flops zu erzeugen, wobei die Phasendifferenz exakt 90° beträgt und die Amplituden identisch sind. Diese Eigenschaften, die für die Meßgenauigkeit sehr wichtig sind, lassen sich bei analogen Sinus bzw. Cosinussignalen nur mit größerem Aufwand erreichen. Die beiden Sensorausgangssignale werden bei Ansteuerung mit rechteckförmigen Signalen in gleicher Weise wie bei der Ansteuerung mit sinus bzw. cosinusförmigen Signalen addiert. Das resultierende Signal besitzt Kreisfrequenzanteile bei $\omega$, $3\omega$, $5\omega$ usw. Jede dieser Kreisfrequenzen besitzt die Phase $K\alpha$, $-K\alpha$, $K\alpha$, ... gegenüber einem Sinussignal mit der entsprechenden Kreisfrequenz. Um die Phase messen zu können ist eine Kreisfrequenz, beispielsweise $\omega$ oder $3\omega$ aus dem Summensignal auszufiltern. Dies kann durch einen Tiefpaß für die Grundwelle $\omega$ oder durch einen Bandpaß für $3\omega$ erfolgen, anschließend wird die Phase wie bereits im Ausführungsbeispiel mit der sinusförmigen Anregung beschrieben mit Hilfe eines Phasenkomparators und eines Mittelungstiefpasses gemessen.

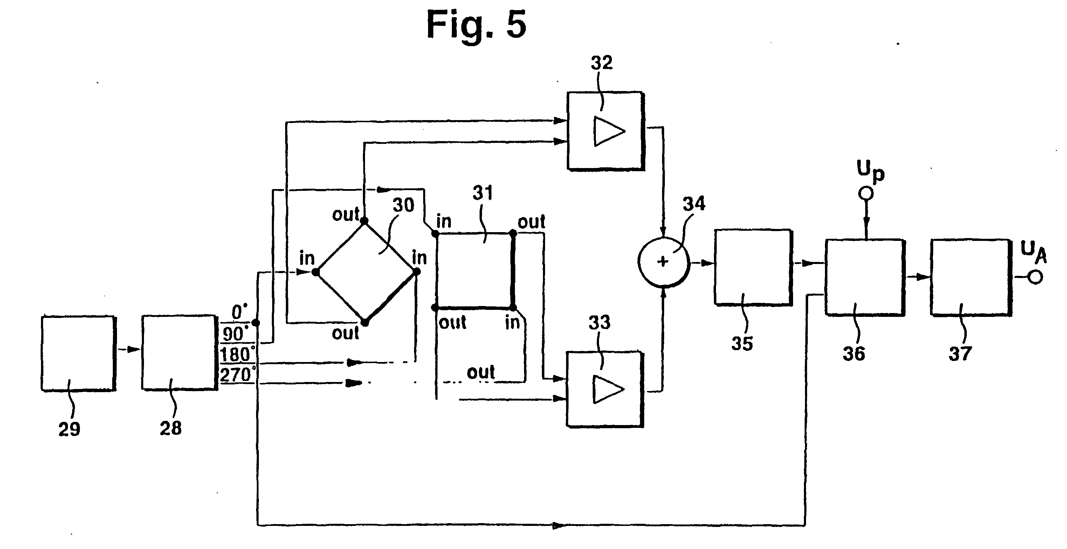

In Figur 5 ist ein Ausführungsbeispiel mit 2 um 45° gegeneinander verdrehten AMR-Sensorelementen und Rechtecksignalanregung als Blockschaltbild angegeben. Eine Einrichtung zur Erzeugung der Rechtecksignale 28, die im einfachsten Fall aus 2 D-Flip-Flops besteht, wird von einem Taktgenerator 29 angesteuert. Der Taktgenerator 29 erzeugt ein Vielfaches, beispielsweise das vierfache der gewünschten Rechteckkreisfrequenz $\omega$. Damit liefert die Rechtecksignalerzeugung nicht nur die 0°- und die 90°-Signale mit 50 % Tastverhältnis, sondern auch deren Komplemente, also 180° und 270°.

Die beiden gegeneinander um einen Winkel von 45° verdrehten Sensorelemente 30, 31 werden mit je einem Gegentaktsignal angesteuert, das über die Eingänge "in" zugeführt wird. Zwei nachgeschaltete Differenzverstärker 32. 33 heben die Sensorsignale um einen Faktor von beispielsweise 50 an. Die am Ausgang der Differenzverstärker 32, 33 entstehenden Signale werden im Summationspunkt 34 addiert. Im nachfolgenden Filter 35 wird das addierte Signal so gefiltert, daß am Ausgang des Filters 35 ein sinusförmiges Ausgangssignal entsteht, das im Phasenkomparator 36 mit dem 0°-Signal verglichen wird. Dem Phasenkomparator 36 wird dazu noch die Spannung $U_p$ zugeführt.

Das vom Phasenkomparator 36 gelieferte Ausgangssignal wird einem Tiefpaßfilter 37 zugeführt. In diesem Tiefpaßfilter wird eine Mittelwertbildung durchgeführt. Wird der Phasenkomparator 36 mit der extern zugeführten Spannung Up betrieben, wird die Ausgangsspannung des Tiefpasses 37 proportional zur Spannung $U_p$ und zum Winkel $K\alpha$. Die Ausgangsspannung $U_A$ am Ausgang des Tiefpasses 37 zeigt dann ein ratiometrisches Verhalten ähnlich der Schleiferspannung bei einem Potentiometer.

Die Nullpunktstabilität des beschriebenen Systems nach Figur 5 hängt vom Temperaturgang der Gruppenlaufzeit des Filters und dem Temperaturgang der Oszillatorfrequenz ab. Um diese Temperaturabhängigkeit zu minimieren, gibt es folgende Möglichkeiten:

1. Der Temperaturgang des Oszillators wird gleich dem Temperaturgang der Gruppenlaufzeit gesetzt. Dies läßt sich beispielsweise durch identische Bauelemente im Oszillator und im Filter erreichen. Die meisten Filterschaltungen lassen sich auch als Oszillator einsetzen, wenn man die Verstärkung entsprechend erhöht oder eine separate Rückkopplung vorsieht.

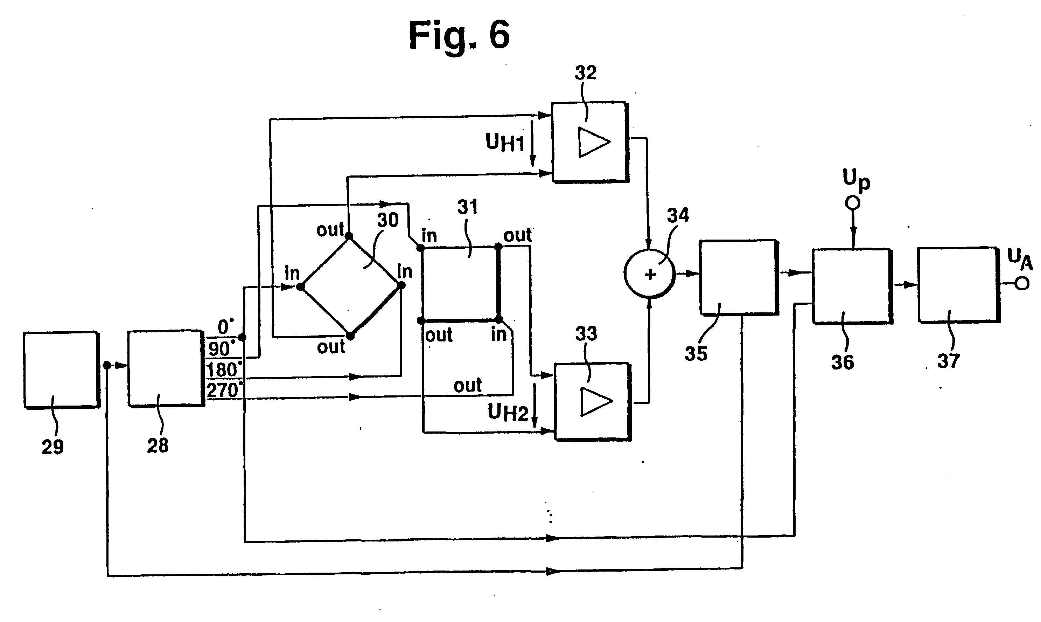

2. Aufbau des Filters in Switched-Capacitor-Technik (SC-Technik) und Takten des Filters mit dem Taktgenerator. Diese Möglichkeit ist im Ausführungsbeispiel nach Figur 6 dargestellt. Die Schaltung nach Figur 6 unterscheidet sich von der Schaltung nach Figur 5 lediglich darin, daß eine zusätzliche Verbindung zwischen dem Taktgenerator 29 und dem als SC-Filter ausgestalteten Filter 35 vorhanden ist.

Da die Grenzfrequenz von SC-Filtern nur von der Taktfrequenz abhängt und die Taktfrequenz ein Vielfaches der Rechteckfrequenz ist, wird mit der in Figur 6 dargestellten Schaltung der Temperaturgang des Nullpunkts nahezu vollständig eliminiert.

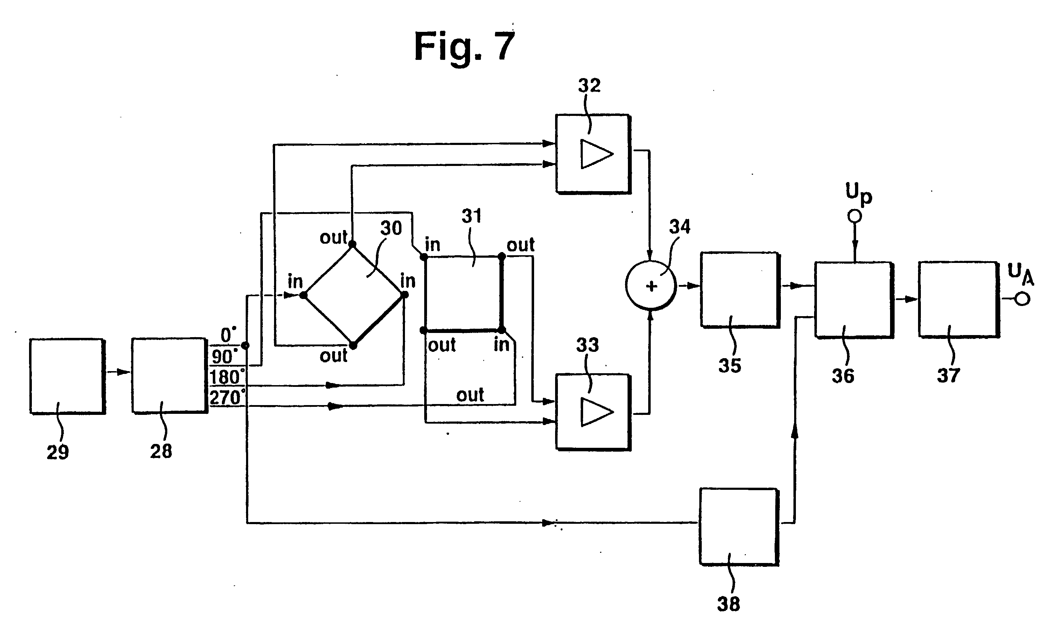

In Figur 7 ist ein weiteres Ausführungsbeispiel dargestellt, bei dem ein zweites Filter 38 vorhanden ist, das zwischen der Rechtecksignalerzeugung 28 und dem Phasenkomparator 36 liegt. Diesem Filter 38 wird das Nullgrad-Rechtecksignal zugeführt. Das Filter 38 sowie das Filter 35 sind identische Filter, wodurch Filter 38 den Temperaturgang der Gruppenlaufzeit von Filter 35 kompensiert.

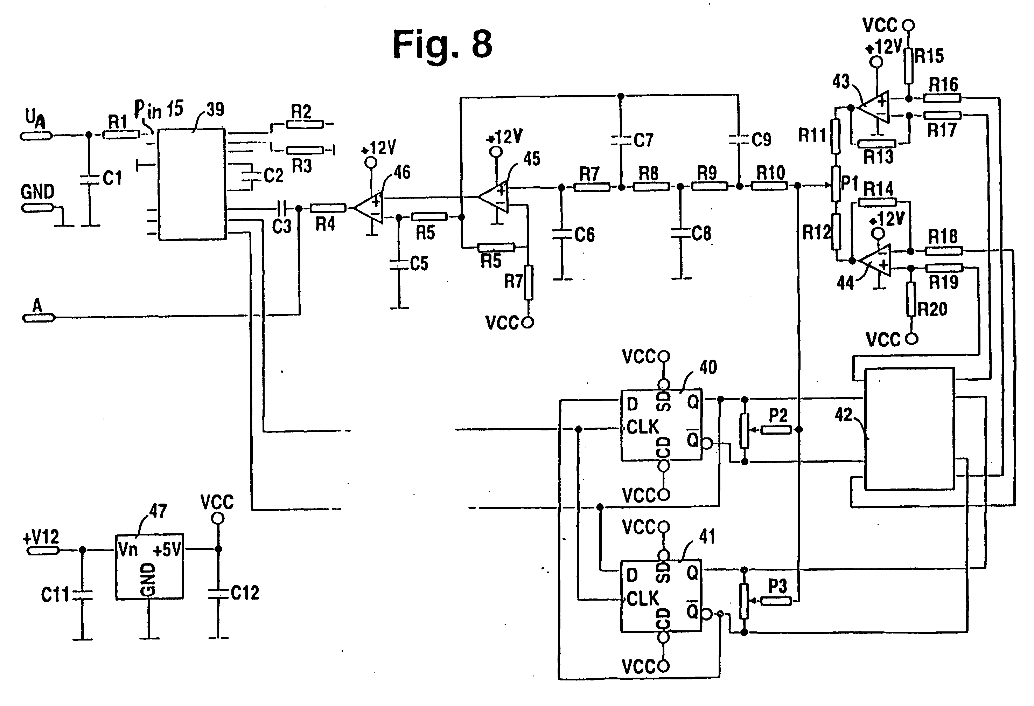

In Figur 8 ist eine konkrete Auswerteschaltung für einen magnetoresistiven Winkelsensor dargestellt. Im einzelnen läßt sich der Aufbau und die Funktion wie folgt erläutern: Ein PLL Baustein 39 enthält den Oszillator, der mit 40 kHz schwingt sowie den Phasenkomparator. Zwei D-Flip-Flops 40, 41 bilden die Rechtecksignalerzeugung, die Ausgangsfrequenz beträgt 10 kHz. Die komplementären Ausgänge sind mit den Eingängen des AMR-Winkelsensors 42 verbunden, der wie in den Figuren 5 bis 7 dargestellt zwei gegeneinander um 45° verdrehte Sensorelemente umfaßt.

Ein Doppeloperationsverstärker 43, 44 stellt den Differenzverstärker dar. Die Summe der beiden Verstärkerausgangssignale gelangt zum Butterworth-Tiefpaß 4. Ordnung mit einer Grenzfrequenz von 10 kHz, der von einem Operationsverstärker 45 samt der zugehörigen Beschaltung gebildet wird. Ein als Komparator geschalteter Operationsverstärker 46 formt das Sinusausgangssignal des Tiefpasses in ein Rechtecksignal um, das vom Phasenkomparator besser als ein Sinussignal verarbeitet werden kann. An Pin 15 des PLL-Bausteines 39 kann das pulsbreitenmodulierte Ausgangssignal abgenommen werden. Am analogen Tiefpaßausgang kann eine zum Winkel proportionale Gleichspannung $U_A$ abgenommen werden. Mit 47 ist die Spannungsversorgung der Gesamtschaltung bezeichnet.

Mit den Potentiometern P1, P2 und P3 können Asymmetrien in den Sensoren und in den Differenzverstärkern kompensiert werden. P1 kompensiert Amplitudenfehler zwischen den beiden Kanälen. P2 und P3 kompensieren Offsetfehler der Sensoren und Übersprechen in der Schaltung. Ein Ersatz der Potentiometer durch digital einstellbare Netzwerke ist bei Integration der Schaltung möglich.

Die in der Schaltung vorhandenen Widerstände und Kondensatoren sowie die erforderlichen Spannungsversorgungen und Masseanschlüsse werden in der Beschreibung nicht näher bezeichnet, sie sind dem Schaltungsbeispiel zu entnehmen.

Mit der in Figur 8 dargestellten Schaltungsanordnung läßt sich ein digitaler Nullpunktabgleich realisieren. Dazu kann eine grobe Verschiebung des Nullpunktes um (mechanisch gesehen) 45°, 90° oder 135° durch Einspeisung des 90°, 180° oder 270° Signales anstelle des 0°-Signales in den Phasenkomparator erfolgen. Eine Feinverschiebung ist durch digitale oder analoge Verzögerung eines der beiden Signale, die zum Phasenkomparator gelangen, möglich. Eine analoge Verschiebung kann beispielsweise durch einen Allpaß, der vorteilhafterweise in SC-Technik ausgestaltet ist, erfolgen. Die Laufzeit dieses Allpasses läßt sich einfach digital programmieren.

Eine digitale Verschiebung kann beispielsweise durch einen programmierbaren Zähler erfolgen, wobei im Interesse einer feinen Quantisierung eine relativ hohe Taktfrequenz zu verwenden ist.

Mit der vorliegenden Schaltung ist auch eine Kompensation der teilweise temperaturabhängigen Sensoreigenschaften durchführbar, eine temperaturabhängige Sensoreigenschaft ist beispielsweise der Sensorinnenwiderstand, der üblicherweise von der Temperatur abhängt. Da der Sensor mit komplementären Rechtecksignalen konstanter Amplitude betrieben wird, ist seine Stromaufnahme zeitlich konstant, jedoch temperaturabhängig. Da der CMOS-Flip-Flop Baustein 40 bzw. 41 bei einer Taktfrequenz von beispielsweise 40 kHz eine vernachlässigbare Stromaufnahme aufweist, ist der Strom, der in der Versorgungsleitung des Flip-Flops fließt, ein direktes Maß für den Strom im Sensor und damit für die Sensortemperatur. Aus der Messung des Stromverbrauchs des Sensors lassen sich somit temperaturabhängige Korrektursignale ableiten, die genau so auf das Summensignal wirken wie die Potentiometer in Figur 8.

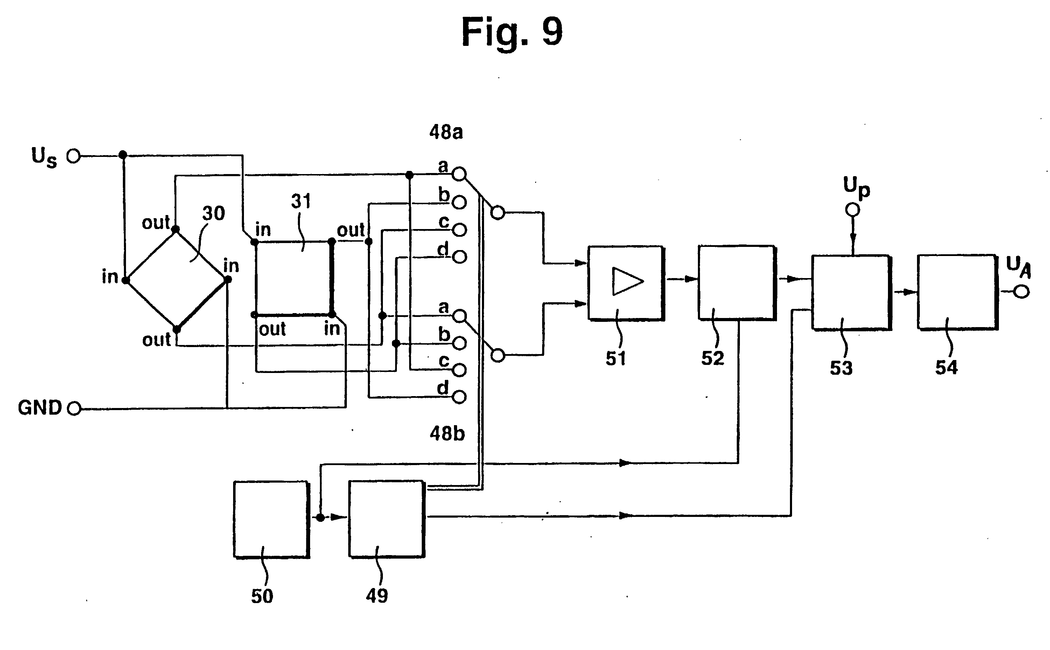

In Figur 9 ist das Blockschaltbild eines weiteren Ausführungsbeispiels in der Erfindung dargestellt. Bei diesem Ausführungsbeispiel wird der Sensor, der die beiden Sensorelemente 30, 31 umfaßt, mit Gleichspannung betrieben. Die beiden Sensorelemente 30, 31 liegen dabei zwischen der Gleichspannung $U_s$ und Masse. Die sich einstellenden Ausgangsspannungen an den beiden Sensorelementen 30, 31 ergeben sich zu:

$$U_{a1}(K\alpha) = C \cdot U_s \cdot \cos(K\alpha)$$

$$U_{a2}(K\alpha) = C \cdot U_s \cdot \sin(K\alpha)$$

Diese Ausgangssignale werden den beiden elektronischen Schaltern 48a, 48b zugeführt, die jeweils die Stellungen, a, b, c, d aufweisen. Beide Schalter durchlaufen periodisch die Stellungen a, b, c, d, a, b, ..... Die Periodendauer eines Umlaufs sei $T_0$, die Verweildauer pro Stellung $T_0/4$. Die Schalter werden von einem Teiler 49, der von einem Taktgenerator 50 getaktet wird, durch entsprechende Signale angesteuert. Ein nachgeschalteter Differenzverstärker 51 erhält somit nacheinander folgende Eingangssignale:

$$U_{a1}(K\alpha), U_{a2}(K\alpha), - U_{a1}(K\alpha), - U_{a2}(K\alpha).$$

Diese periodische Signalfolge beschreibt eine mit der Abtastfrequenz $4/T_0$ abgetastete treppenförmige Cosinusspannung $U_t$ mit der Frequenz $1/T_0$ und der Phase $-K\alpha$, die folgendermaßen dargestellt werden kann:

$$U_t = C \cdot U_s \cdot \cos(2\pi \cdot t/T_0 - K\alpha)$$

$$\text{mit} = 0, T_0/4, 2T_0/4, 3T_0/4, \ldots.$$

Im Differenzverstärker 51 wird dieses Signal um einen vorgebbaren Faktor, beispielsweise um 50, angehoben. Das nachfolgende Filter 52, das vorzugsweise in Switched-Capacitor-Technik aufgebaut ist, erzeugt daraus ein sinusförmiges Ausgangssignal, das im Phasenkomparator 36 mit dem 0°-Signal, das ebenfalls vom Teiler geliefert wird, verglichen wird. Das nachgeschaltete Tiefpaßfilter 54 führt die Mittelwertbildung des pulsbreitenmodulierten Phasenmeßsignals durch. Wird der Phasenkomparator mit der extern zugeführten Spannung $U_p$ betrieben, wird die Ausgangsspannung des Tiefpasses proportional zu $U_p$ und den Winkel $K\alpha$, es ergibt sich dann wiederum ein ratiometrisches Verhalten wie beispielsweise bei einem Potentiometer. Das Switched-Capacitor-Filter wird direkt vom Taktgenerator 50 getaktet.

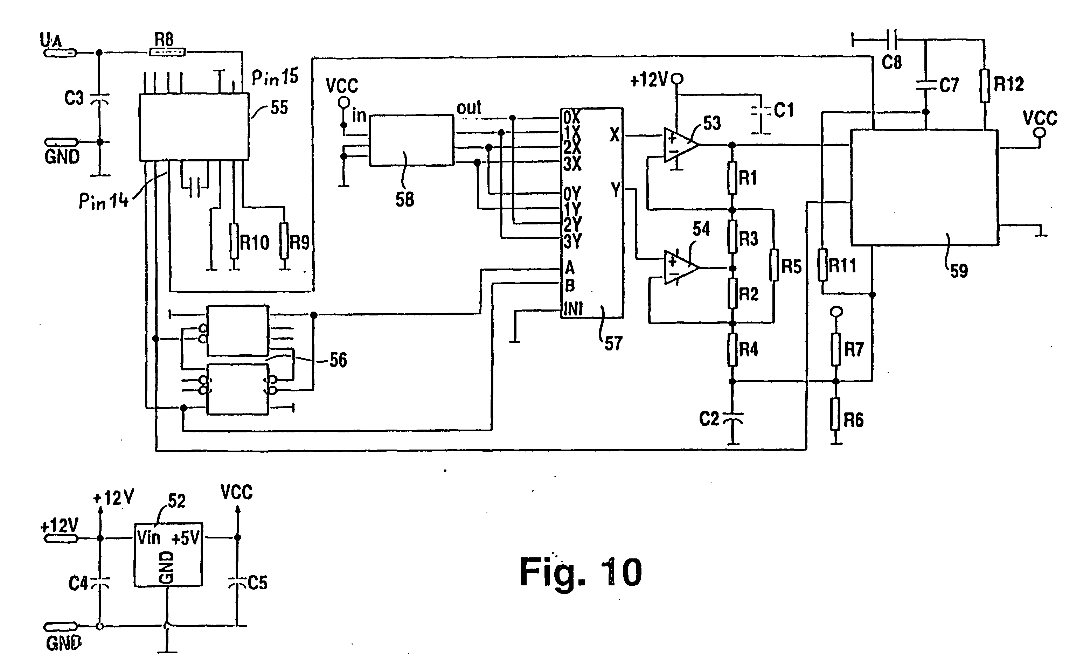

In Figur 10 ist ein ausführliches Schaltungsbeispiel dargestellt, dessen wesentliche Bauteile im folgenden näher bezeichnet werden. Ein PLL-Baustein 55 enthält den Oszillator, der mit einem Megahertz schwingt. Außerdem umfaßt der PLL-Baustein 55 den Phasenkomparator. Mit 56 ist ein Freqenzteiler bezeichnet, der zunächst durch 25 und anschließend durch 4 teilt. Die Ausgänge an Pin 3 bzw. 13 des Frequenzteilers liefern somit ein 20 kHz bzw. ein 10 kHz Schaltsignal an den zweikanaligen Multiplexer 57, an dessen Eingängen der Sensor 58 wie oben beschrieben, angeschlossen ist. Zwischen den Ausgängen X und Y entsteht die bereits erwähnte treppenförmige Cosinusspannung $U_t$ mit der Frequenz 10 kHz und der Abtastfrequenz 40 kHz, die vom Differenzverstärker 53, 54 verstärkt wird. Die Filterung erfolgt im Switched-Capacitor-Filter 59, das mit einem Megahertz aus dem Oszillator getaktet wird. Die Grenzfrequenz des SC-Filters beträgt ein Megahertz/ 100 = 10 kHz.

Infolge dieser Zusammenhänge ist die Spannung am Filterausgang rein sinusförmig. Ein frei verfügbarer Operationsverstärker im SC-Filter sei als Komparator konfiguriert, der die Sinusspannung in eine Rechteckspannung gleicher Phase überführt. Die Rechteckspannung wird zum Phasenkomparator geführt und dort mit dem 0°-Signal (Pin 13) verglichen.

Das pulsbreitenmodulierte Ausgangssignal kann an Pin 15 abgenommen werden. Am analogen Tiefpaßausgang erscheint eine zum Winkel proportionale Gleichspannung $U_A$.

Die Spannungsversorgung der genannten Schaltung ist schematisch als Schaltung 52 dargestellt.

**Patentansprüche**

**1.** Anordnung zur berührungslosen Drehwinkelerfassung eines drehbaren Elements, bei der,

- unter Auswertung von magnetisch beeinflußbaren Eigenschaften einer Sensoranordnung, mit wenigstens zwei Sensorelementen (6, 7, 30, 31), eine vom drehbaren Element erzeugte oder beeinflußte magnetische Feldstärke (B) in einer Auswerteschaltung detektierbar und zur Ermittlung der Drehlage heranziehbar ist, und

- die Auswerteschaltung derart ausgebildet ist, daß die Sensorelemente (6, 7, 30, 31) jeweils mit einem um 90° gegeneinander phasenverschobenen Wechselstrom ($I_1$, $I_2$) bzw. einer entsprechenden Wechselspannung versorgt werden, die wie folgt gebildet sind:

$$I_1(t) = I0 \cdot \cos(\omega \cdot t)$$

$$I_2(t) = I0 \cdot \sin(\omega \cdot t),$$

daß

- die Spannung ($U_{H1}$, $U_{H2}$) an Ausgängen der Sensorelemente sich wie folgt ergeben:

$$U_{H1}(t,\alpha) = C_1 \cdot B_1 \cdot \cos(K\alpha) \cdot I_1(t)$$

und

$$U_{H2}(t,\alpha) = C_2 \cdot B_2 \cdot \cos(K\alpha) \cdot I_2(t)$$

wobei

- C1 und C2 Konstanten und $B_1$ und $B_2$ die Feldkomponenten sind, **dadurch gekennzeichnet, daß** gilt: $C_1 = C_2 = C$ und $B_1 = B_2 = B$ und

- daß die Konstante K = 1 für Hall-Sensorelemente (6,7) bzw. = 2 für AMR-Sensorelemente (30, 31) ist, daß

- in einer Summationsschaltung (23) die Summe aus den beiden Spannungen $U_{H1}(t)$ und $U_{H2}(t)$ gebildet wird und daß

- in einem Phasenkomparator (25) mit wenigstens einem nachfolgenden Filter (27, 37) der ursprüngliche Wechselstrom und das Ausgangssignal der Summenschaltung (23) verarbeitet werden, wobei das Filter (27, 37) ein Tiefpaß ist, der das Ausgangssignal des Phasenkomparators so glättet, daß am Ausgang des Filters (27, 37) ein dem Drehwinkel ($\alpha$) proportionales Ausgangssignal ($U_A$) entsteht.

**2.** Anordnung nach Anspruch 1, **dadurch gekennzeichnet, daß** anstatt der Phasenverschiebung des Stroms eine Spannung nach dem Sensorelement (6, 7, 30, 31)um 90° phasenverschoben wird.

3.  Anordnung nach Anspruch 1 oder 2, **dadurch gekennzeichnet, daß** die zwei Sensorelemente (6, 7) Hallsensoren sind.

4.  Anordnung nach Anspruch 3, **dadurch gekennzeichnet, daß**

    -   die Sensoranordnung (5) aus vertikal, parallel zur Drehachse gerichteten Hallsensoren (6, 7) aufgebaut und derart dem drehbaren Element (2) gegenüber angeordnet ist, daß die vom drehbaren Element (2) ausgehend Feldlinien (B) in jeder Drehlage quer zu den von der Richtung eines Stromes (I) in den Hallsensoren (6, 7) vorgegebenen Hallstrukturen verlaufen und daß
    -   die sich durch eine Drehwinkeländerung ($\alpha$) ergebende Änderung der Richtungskomponenten der Feldlinien (B) in der Auswerteschaltung auswertbar sind.

5.  Anordnung nach Anspruch 4, **dadurch gekennzeichnet, daß** zwei, gegeneinander um 90° versetzte Hallsensoren (6, 7) als Bestandteil der Sensoranordnung (5) vorhanden sind, deren jeweilige Hallspannungen ($U_{H1}$, $U_{H2}$) in einer zur Drehachse rechtwinklig liegenden Ebene annehmbar sind und jeweils um 90° verschiedene Richtungskomponenten der Feldlinien (B) detektieren.

6.  Anordnung nach einem der vorhergehenden Ansprüche, **dadurch gekennzeichnet, daß**

    -   das bewegliche Element ein Dauermagnet (2) ist, der rotationssymmetrisch auf der Stirnseite einer sich drehenden Welle (1) angeordnet ist und in den gegenüberliegenden Hallsensor (6, 7) eine Änderung der Hallspannungen ($U_{H1}$, $U_{H2}$) nach folgenden Beziehungen verursacht:

    $$U_{H1} = C_1 \cdot I_1 \cdot B \cdot \cos \alpha,$$

    $$U_{H2} = C_2 \cdot I_2 \cdot B \cdot \sin \alpha,$$

    wobei:

    $U_{H1}$ die Hallspannung des Hallsensors (6),
    $U_{H2}$ die Hallspannung des um 90° versetzten Hallsensors (7),
    $C_1$, $C_2$ Materialkonstanten der Hallsensoren (6 und 7),
    B die senkrecht zur Ebene der Hallsensoren (6 und 7) auftretende magnetische Feldstärke (unter der Vorraussetzung, daß die Feldstärke an beiden Hallsensoren (6 und 7) gleich ist ($B_1$ = $B_2$) und $\alpha$ der Drehwinkel des sich drehenden Elements (Magnet 2) ist.

7.  Anordnung nach Anspruch 1, **dadurch gekennzeichnet, daß**

    -   die zwei Sensorelemente (30, 31) um 45° gegeneinander verdrehte AMR-Sensoren sind.

8.  Anordnung nach Anspruch 7, **dadurch gekennzeichnet, daß**

    -   der Drehwinkel des drehbaren Elementes (2) durch die Verknüpfung der Beziehungen

    $$U_{H1} = C_1 \cdot I_1 \cdot B \cdot \cos \alpha,$$

    $$U_{H2} = C_2 \cdot I_2 \cdot B \cdot \sin \alpha,$$

    entsprechend

    $$K\alpha = \arctan (U_{H1}/U_{H2})$$

    in einer nachgeschalteten Auswerteschaltung bestimmbar ist.

9.  Anordnung nach einem der Ansprüche 2 bis 6, **dadurch gekennzeichnet, daß**

    -   die Hallsensoren (6, 7) Bestandteil eines mikromechanisch bearbeitbaren Halbleiter-Wafers sind, dessen Waferebene rechtwinklig zur Drehachse liegt, daß
    -   die Hallstruktur der Hallsensoren (6, 7) in denen der Strom (I) fließt, vertikal zur Waferebene verläuft und daß
    -   in den Halbleiter-Wafer ebenfalls eine Auswerteschaltung oder Teile davon integriert sind.

10. Anordnung nach Anspruch 9, **dadurch gekennzeichnet, daß**

    -   der Halbleiter-Wafer aus Silizium hergestellt ist.

11. Anordnung nach einem der vorhergehenden Ansprüche, **dadurch gekennzeichnet, daß**

    -   als Wechselströme ($I_1$, $I_2$) rechteckförmige Signale mit der Kreisfrequenz $\omega$ und einem Tastverhältnis von 50 % verwendet werden, die gegeneinander um eine Viertelperiode verschoben sind und zur Versorgung der beiden Sensorelemente (6, 7, 30, 31) dienen und in einer Einrichtung zur Erzeugung der Rechtecksignale (28) gebildet werden,

- daß die Ausgangssignale der beiden Sensorelemente (6, 7, 30, 31) jeweils einem mit der Summationsschaltung (34) in Verbindung stehenden Verstärker (32, 33) zugeführt werden, wobei das Ausgangssignal der Summationsschaltung (34) im mit einer extern zuführbaren Spannung betriebenen Phasenkomparator (36) zur Erzeugung eines vom Drehwinkel abhängigen Ausgangssignales (UA) verarbeitet wird.

12. Anordnung zur berührungslosen Drehwinkelerfassung eines drehbaren Elements, bei der,

- unter Auswertung von magnetisch beeinflußbaren Eigenschaften einer Sensoranordnung, mit wenigstens zwei Sensorelementen (6, 7, 30, 31), eine vom drehbaren Element erzeugte oder beeinflußte magnetische Feldstärke (B) in einer Auswerteschaltung detektierbar und zur Ermittlung der Drehlage heranziehbar ist, und
- die Auswerteschaltung derart ausgebildet ist, daß die Sensorelemente (6, 7, 30, 31) jeweils mit einer Spannung ($U_s$) versorgt werden, **dadurch gekennzeichnet, daß** die Spannung ($U_s$) eine Gleichspannung ist, daß sich die Ausgangsspannungen der Sensorelemente (6, 7, 30, 31) ergeben zu:

$$U_a (K\alpha) = C \cdot U_s \cdot \cos (K\alpha)$$

$$U_a (K\alpha) = C \cdot U_s \cdot \sin (K\alpha),$$

- daß die Konstante K = 1 für Hall-Sensorelemente (6, 7) bzw. = 2 für AMR-Sensorelemente (30, 31) ist ,
- daß die Ausgangsspannungen $U_{a1}$ ($K\alpha$), $U_{a2}$ ($K\alpha$) zwei Schaltmitteln (48a, 48b) zugeführt werden, die ihre Schaltstellungen periodisch durchlaufen
- und daß die Ausgangssignale der Schaltmittel (48a, 48b) einem Verstärker (51) zugeführt werden und über ein Filter (52) zum Phasenkomparator (36) gelangen und im Phasenkomparator (36) zur Erzeugung eines vom Drehwinkel abhängigen Ausgangssignales verarbeitet werden, das in einem nachfolgenden Tiefpaßfilter (54) so geglättet wird, daß an seinem Ausgang ein dem Drehwinkel (a) proportionales Ausgangssignal ($U_A$) entsteht.

13. Anordnung nach einem der vorhergehenden Ansprüche, **dadurch gekennzeichnet, daß** die Filter (27, 37) als Switched-Capacitor-Filter aufgebaut sind.

14. Anordnung nach einem der vorhergehenden Ansprüche, **dadurch gekennzeichnet, daß**

- der zu erfassende Winkel $\alpha$ der Drehwinkel einer Welle in einem KFZ ist.

**Claims**

1. Arrangement for the contactless detection of the angle of rotation of a rotatable element, in which,

- with the evaluation of magnetically influencable properties of a sensor arrangement, having at least two sensor elements (6, 7, 30, 31), a magnetic field strength (B) which is generated or influenced by the rotatable element can be detected in an evaluation circuit and be used for determining the rotational position, and
- the evaluation circuit is designed in such a way that the sensor elements (6, 7, 30, 31) are each supplied with an alternating current ($I_1$, $I_2$), phase-shifted by 90° relative to one another, or a corresponding alternating voltage, which are formed as follows:

$$I_1 (t) = I0 \cdot \cos (\omega \cdot t)$$

$$I_2 (t) = I0 \cdot \sin (\omega \cdot t),$$

that

- the voltages ($U_{H1}$, $U_{H2}$) at outputs of the sensor elements are produced as follows:

$$U_{H1} (t,\alpha) = C_1 \cdot B_1 \cdot \cos (K\alpha) \cdot I_1 (t)$$

and

$$U_{H2} (t,\alpha) = C_2 \cdot B_2 \cdot \cos (K\alpha) \cdot I_2 (t)$$

where

- C1 and C2 are constants and $B_1$ and $B_2$ are the field components, **characterized in that** the following holds true: $C_1 = C_2 = C$ and $B_1 = B_2 = B$, and
- **in that** the constant K = 1 for Hall sensor elements (6, 7) and = 2 for AMR sensor elements (30, 31), **in that**
- the sum of the two voltages $U_{H1}$ (t) and $U_{H2}$ (t) is formed in a summation circuit (23), and **in that**

- the original alternating current and the output signal of the summation circuit (23) are processed in a phase comparator (25) with at least one downstream filter (27, 37), the filter (27, 37) being a low-pass filter which smoothes the output signal of the phase comparator in such a way that an output signal ($U_A$) which is proportional to the angle ($\alpha$) of rotation is produced at the output of the filter (27, 37).

2. Arrangement according to Claim 1, **characterized in that**, instead of the phase shift of the current, a voltage, downstream of the sensor element (6, 7, 30, 31), is phase-shifted by 90°.

3. Arrangement according to Claim 1 or 2, **characterized in that** the two sensor elements (6, 7) are Hall sensors.

4. Arrangement according to Claim 3, **characterized in that**

   - the sensor arrangement (5) is constructed from Hall sensors (6, 7) which are directed vertically, parallel to the axis of rotation, and is arranged opposite the rotatable element (2) in such a way that the field lines (B) emerging from the rotatable element (2), in every rotational position, run transversely with respect to the Hall structures prescribed by the direction of a current (I) in the Hall sensors (6, 7), and **in that**
   - the change in the directional components of the field lines (B) which results from an angle-of-rotation change ($\alpha$) can be evaluated in the evaluation circuit.

5. Arrangement according to Claim 4, **characterized in that** two Hall sensors (6, 7) which are offset by 90° relative to one another are present as part of the sensor arrangement (5), whose respective Hall voltages ($U_{H1}$, $U_{H2}$) can be accepted in a plane lying at right angles to the axis of rotation and detect directional components of the field lines (B) that differ by 90° in each case.

6. Arrangement according to one of the preceding claims, **characterized in that**

   - the moveable element is a permanent magnet (2), which is arranged rotationally symmetrically on the end of a rotating shaft (1) and, in the opposite Hall sensor (6, 7), causes a change in the Hall voltages ($U_{H1}$, $U_{H2}$) according to the following relationships:

$$U_{H1} = C_1 \cdot I_1 \cdot B \cos \alpha,$$

$$U_{H2} = C_2 \cdot I_2 \cdot B \sin \alpha,$$

where:

   $U_{H1}$ is the Hall voltage of the Hall sensor (6),
   $U_{H2}$ is the Hall voltage of the Hall sensor (7) offset by 90°,
   $C_1$, $C_2$ are material constants of the Hall sensors (6 and 7),
   B is the magnetic field strength occurring perpendicularly to the plane of the Hall sensors (6 and 7) (assuming that the field strength is identical ($B_1 = B_2$) at both Hall sensors (6 and 7) and $\alpha$ is the angle of rotation of the rotating element (magnet 2)).

7. Arrangement according to Claim 1, **characterized in that**

   - the two sensor elements (30, 31) are AMR sensors rotated by 45° relative to one another.

8. Arrangement according to claim 7, **characterized in that**

   - the angle of rotation of the rotatable element (2) can be determined by the linking of the relationships

$$U_{H1} = C_1 \cdot I_1 \cdot B \cdot \cos \alpha,$$

$$U_{H2} = C_2 \cdot I_2 \cdot B \cdot \sin \alpha,$$

   in accordance with

$$K\alpha = \arctan (U_{H2}/U_{H2})$$

   in an evaluation circuit connected downstream.

9. Arrangement according to one of Claims 2 to 6, **characterized in that**

   - the Hall sensors (6, 7) are part of a micromechanically processable semiconductor wafer whose wafer plane lies at right angles to the axis of rotation, **in that**
   - the Hall structure of the Hall sensors (6, 7) in which the current (I) flows runs vertically with respect to the wafer plane, and **in that**
   - an evaluation circuit or parts thereof is or are likewise integrated into the semiconductor wafer.

10. Arrangement according to Claim 9, **characterized**

**in that**

- the semiconductor wafer is fabricated from silicon.

11. Arrangement according to one of the preceding claims,
**characterized in that**

- square-wave signals having the angular frequency $\omega$ and a duty ratio of 50% are used as the alternating currents ($I_1$, $I_2$), which signals are shifted by a quarter-cycle relative to one another and serve for supplying the two sensor elements (6, 7, 30, 31) and are formed in a device for generating the square-wave signals (28),
- **in that** the output signals of the two sensor elements (6, 7, 30, 31) are respectively fed to an amplifier (32, 33) connected to the summation circuit (34), the output signal of the summation circuit (34) being processed in the phase comparator (36), operated with a voltage that can be fed in externally, for generating an output signal (UA) which is dependent on the angle of rotation.

12. Arrangement for the contactless detection of the angle of rotation of a rotatable element, in which,

- with the evaluation of magnetically influencable properties of a sensor arrangement, having at least two sensor elements (6, 7, 30, 31), a magnetic field strength (B) which is generated or influenced by the rotatable element can be detected in an evaluation circuit and be used for determining the rotational position, and
- the evaluation circuit is designed in such a way that the sensor elements (6, 7, 30, 31) are each supplied with a voltage ($U_s$), **characterized in that** the voltage ($U_s$) is a DC voltage, **in that** the output voltages of the sensor elements (6, 7, 30, 31) are produced as:

$$U_a\,(K\alpha) = C \cdot U_s \cdot \cos\,(K\alpha)$$

$$U_a\,(K\alpha) = C \cdot U_s \cdot \sin\,(K\alpha),$$

- **in that** the constant K = 1 for Hall sensor elements (6, 7) and = 2 for AMR sensor elements (30, 31),
- **in that** the output voltages $U_{a1}$ ($K\alpha$), $U_{a2}$ ($K\alpha$) are fed to two switching means (48a, 48b), which periodically traverse their switching positions,
- and **in that** the output signals of the switching means (48a, 48b) are fed to an amplifier (51) and pass via a filter (52) to the phase comparator (36) and are processed in the phase comparator (36) for the purpose of generating an output signal which is dependent on the angle of rotation and is smoothed in a downstream low-pass filter (54) in such a way that an output signal ($U_A$) which is proportional to the angle ($\alpha$) of rotation is produced at its output.

13. Arrangement according to one of the preceding claims, **characterized in that** the filters (27, 37) are constructed as switched-capacitor filters.

14. Arrangement according to one of the preceding claims,
**characterized in that**

- the angle $\alpha$ to be detected is the angle of rotation of a shaft in a motor vehicle.

**Revendications**

1. Montage pour la saisie sans contact de l'angle de rotation d'un élément rotatif selon lequel

- en exploitant les propriétés influençables magnétiquement d'un montage de capteur comprenant au moins deux éléments de capteurs (6, 7, 30, 31), on détecte une intensité de champ magnétique (B) généré par l'élément tournant ou influencé par celui-ci dans un circuit de traitement et on l'utilise pour déterminer la position de rotation, et
- on réalise le circuit de traitement pour que les éléments de capteurs (6, 7, 30, 31) reçoivent chaque fois un courant alternatif ($I_1$, $I_2$) en déphasage de 90° représenté par les formules suivantes :

$$I_1\,(t) = I0 \cdot \cos\,(\varphi.t)$$

$$I_2\,(t) = I0 \cdot \sin\,(\varphi.\,t)$$

- ou une tension alternative correspondante la tension ($U_{H1}$, $U_{H2}$) aux sorties des éléments de capteur donnée par les formules suivantes :

$$U_{H1}\,(t,\alpha) = C_1 \cdot B_1 \cdot \cos\,(k\alpha) \cdot I_1\,(t)$$

$$U_{H2}\,(t,\alpha) = C2 \cdot B_2 \cdot \cos\,(K\alpha) \cdot I_2\,(t)$$

$C_1$, $C_2$ étant des constantes et $B_1$, $B_2$ représen-

tant les constantes de champ,

**caractérisé en ce que**
on a C1 = C2 = C et B1 = B2 = B, et

- la constante A est égale à 1 pour des capteurs Hall (6,7) ou est égale à 2 pour des éléments de capteur AMR (30, 31),
- un circuit de sommation (23) forme la somme des deux tensions ($U_{H1}$ (t), $U_{H2}$ (t)) et
- un comparateur de phase (25) avec au moins un filtre (27, 37) en aval traite le courant alternatif d'origine et le signal de sortie du circuit additionneur (23), le filtre (27, 37) étant un filtre passe-bas qui lisse le signal de sortie du comparateur de phase de façon à obtenir à la sortie du filtre (27, 37) un signal de sortie ($U_A$ proportionnel à l'angle de rotation ($\alpha$).

2. Montage selon la revendication 1,
**caractérisé en ce qu'**
à la place du déphasage du courant on a une tension déphasée de 90° après l'élément de capteur (6, 7, 30, 31).

3. Montage selon la revendication 1 ou 2,
**caractérisé en ce que**
les deux éléments de capteur (6, 7) sont des capteurs Hall.

4. Montage selon la revendication 3,
**caractérisé en ce que**

- le montage de capteur (5) est formé de capteurs Hall (6, 7) verticaux, parallèles à l'axe de rotation et ce montage est installé en face de l'élément rotatif (2) pour que les lignes de champ (B) partant de l'élément rotatif (2), dans chaque position de rotation, passent transversalement aux structures Hall prédéfinies par la direction du courant (I) dans les capteurs Hall (6, 7), et
- la variation des composantes de direction de ligne de champ (B) résultant de la variation de l'angle de rotation ($\alpha$) exploitée dans le circuit d'expédition.

5. Montage selon la revendication 4,
**caractérisé en ce que**
deux capteurs Hall (6, 7) décalés de 90° l'un par rapport à l'autre font partie du montage de capteur (5) et leur tension Hall respective ($U_{H1}$, $U_{H2}$) peuvent être prises dans un plan perpendiculaire à l'axe de rotation pour détecter chaque fois les composantes directionnelles décalées de 90° des lignes de champ (B).

6. Montage selon l'une quelconque des revendications précédentes,
**caractérisé en ce que**
l'élément mobile est un aimant permanent monté symétrique en rotation sur la face frontale de l'un des arbres tournants (1) et qui dans les capteurs Hall (6, 7) opposés, produit une variation des tensions ($U_{H1}$, $U_{H2}$) selon les relations suivantes :

$$U_{H1} = C_1 . I_1 . B . \cos \alpha$$

$$U_{H2} = C_2 . I_2 . B . \sin \alpha$$

dans lesquelles :

$U_{H1}$ : tension Hall du capteur Hall (6),
$U_{H2}$ : tension Hall du capteur Hall (7) décalé de 90° par rapport au précédent,
C1, C2 : constantes de la matière des capteurs Hall (6, 7),
B : intensité du champ magnétique perpendiculaire au plan des capteurs Hall (6, 7), dans l'hypothèse que l'intensité du champ sur les deux capteurs Hall (6, 7) soit égale (B1 = B2) et
$\alpha$ : angle de rotation d'élément rotatif (aimant (2)).

7. Montage selon la revendication 1,
**caractérisé en ce que**
les deux éléments de capteurs (30, 31) sont des capteurs AMR tournés à 45° l'un de l'autre.

8. Montage selon la revendication 7,
**caractérisé en ce que**
l'angle de rotation de l'élément rotatif (2) est défini par la combinaison des relations

$$U_{H1} = C_1 . I_1 . B . \cos \alpha$$

$$U_{H2} = C_2 . I_2 . B . \sin \alpha$$

selon la formule

$$k\alpha = \arctan (U_{H1}/U_{H2})$$

dans un circuit d'exploitation en aval.

9. Montage selon l'une des revendications 2 à 6,
**caractérisé en ce que**

- les capteurs Hall (6, 7) font partie d'une puce semi-conductrice traitée en technique micromécanique dont le plan de la puce est perpendiculaire à l'axe de rotation,

- la structure Hall des capteurs Hall (6,7) dans lesquels passe le courant (I) est verticale par rapport au plan de la puce, et
- dans la puce semi-conductrice on a intégré également un circuit de traitement ou des parties de celui-ci.

10. Montage selon la revendication 9,
**caractérisé en ce que**
la puce semi-conductrice est en silicium.

11. Montage selon l'une des revendications précédentes,
**caractérisé en ce que**

- les courants alternatifs (I1, I2) sont des signaux rectangulaires de pulsation ω et de rapport de travail égal à 50 %, ces signaux présentant un décalage d'un quart de période et servant à l'alimentation des deux éléments de capteur (6, 7, 30, 31) en étant montés dans une installation pour générer des signaux rectangulaires (28), et
- les signaux de sortie des deux éléments de capteur (6, 7, 30, 31) sont fournis chaque fois à un amplificateur (32, 33) relié au circuit de sommation (34),
- le signal de sortie du circuit de sommation (34) étant traité dans un comparateur de phase (36) utilisant une tension d'origine extérieure pour générer un signal de sortie (U$_A$) dépendant de l'angle de rotation.

12. Montage de saisie sans contact de l'angle de rotation d'un élément tournant selon lequel

- en exploitant les propriétés d'influence magnétique d'un montage de capteur avec au moins deux éléments de capteurs (6, 7, 30, 31) on détecte une intensité de champ magnétique (B) généré par l'élément tournant ou influencé par celui-ci, dans un circuit d'exploitation et on l'utilise pour déterminer la position de rotation et,
- le circuit d'exploitation est réalisé pour que les éléments de capteurs (6, 7, 30, 31) reçoivent chaque fois une tension (U$_s$),

  **caractérisé en ce que**

- la tension (U$_s$) est une tension continue, les tensions sorties des éléments de capteur (6, 7, 30, 31) correspondent aux relations suivantes :

$$U_a (k\alpha) = C \cdot U_s \cdot \cos (k\alpha)$$

$$U_a (k\alpha) = C \cdot U_s \cdot \sin (k\alpha),$$

- la constante K = 1 pour des éléments de capteur Hall (6, 7) et cette constante est égale à 2 pour des éléments de capteur AMR (30, 31),
- de commutation (48a, 48b) qui parcourent périodiquement leur position de commutation, et
- les signaux de sortie des moyens de commutation (48a, 48b) sont fournis à l'amplificateur (51) et arrivent par l'intermédiaire d'un filtre (52) à un comparateur de phase (36) pour être traités dans ce comparateur de phase (36) pour générer un signal de sortie dépendant de l'angle de rotation, ce signal étant lissé dans un filtré passe-bas (54) suivant, dont la sortie fournit en sortie un signal (U$_A$) proportionnel à l'angle de rotation (α).

13. Montage selon l'une des revendications précédentes,
**caractérisé en ce que**
le filtre (27, 37) est un filtre à condensateur commuté (filtre SC).

14. Montage selon l'une des revendications précédentes,
**caractérisé en ce que**
l'angle (α) détecté est l'angle dé rotation d'un arbre d'un véhicule automobile.

# Fig. 1

# Fig. 2

# Fig. 3

$$U_A = \text{const.} \arctan(U_{H1}, U_{H2})$$

# Fig. 4

Fig. 5

# Fig. 6

# Fig. 7

EP 0 740 776 B1

# Fig. 8

EP 0 740 776 B1

# Fig. 9

EP 0 740 776 B1

**Fig. 10**

EP 0 740 776 B1